# EUROPEAN PATENT APPLICATION

(11) **EP 2 296 156 A1**
(43) Date of publication of application: **16.03.2011**
(21) Application number: 09167796.3
(22) Date of filing: 13.08.2009
(51) Int. Cl.: H01G 4/38, H05K 1/14, H01G 9/26

(54) **Composite capacitance and use thereof**

(71) Applicant: ABB Research Ltd, 8050 Zürich (CH)
(72) Inventor: Cottet, Didier, CH-8050 Zürich (CH)
(74) Representative: ABB Patent Attorneys

(57) **Abstract**

A composite capacitive component comprises a plurality of physically distinguishable capacitor modules which are electrically connected to each other. The distinguishable modules allow for an increased electrical and/or geometrical flexibility in designing the capacitive component. Each of the capacitor modules comprises a plurality of base capacitors arranged on a module-specific Printed Circuit Board PCB. All the base capacitors from the capacitor modules are of a single type, which simplifies both production and maintenance of the capacitive component.

## Description

### Technical Field

The invention relates to the field of capacitive components for electric power devices, and in particular to a composite capacitance used as a DC-link capacitance in an electric power frequency converter.

### Background Art

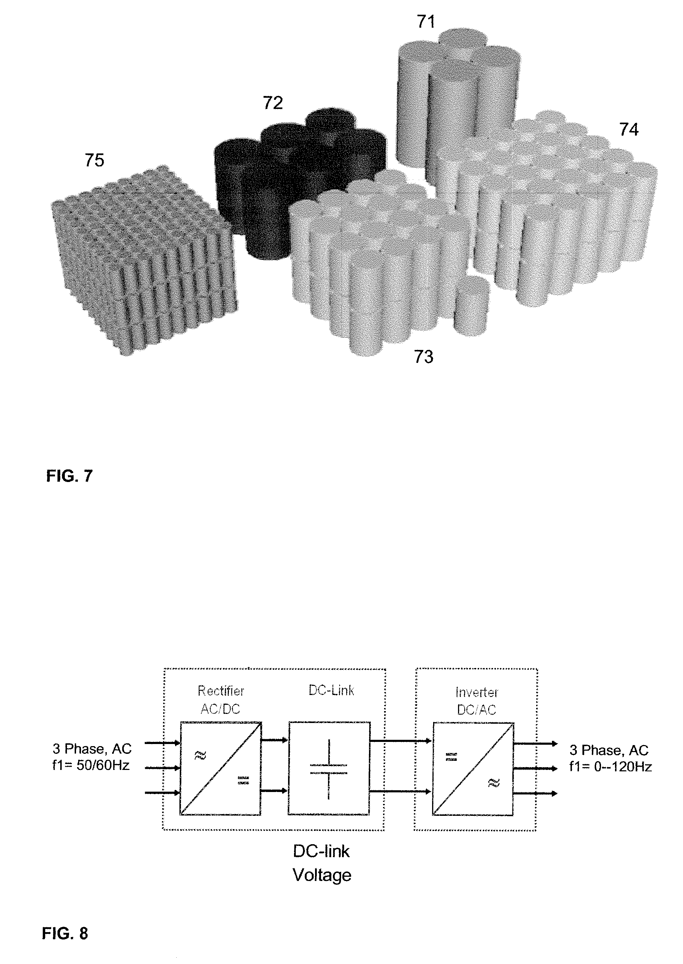

An electric power frequency converter converts a single or three phase alternating voltage into an alternating voltage with another frequency and/or phase number. A state-of-the-art frequency converter as depicted in Fig.8 comprises typically a rectifier converting alternating current (AC) to direct current (DC), an inverter converting direct current (DC) to alternating current (AC), as well as a DC link connecting the rectifier and inverter. The DC link comprises a capacitive component acting as energy storage and filter for the DC-link voltage.

A conventional capacitive component used in a power frequency converter or other power device comprises one or several capacitors which are mounted directly on a main circuit board of the power frequency converter and tend to occupy a large area on the main circuit board. In addition, for a manufacturer of a range of power devices based on capacitors from a plurality of distinct capacitor types the supply chain management is an important issue. Finally, replacement of a failed capacitor on the main circuit board might be time-consuming and onerous.

Thus, it is an object of the present invention to create a capacitive component which overcomes the abovementioned drawbacks.

### Brief Summary of the Invention

According to the present invention, a composite capacitance is proposed which comprises a plurality of physically distinguishable capacitor modules electrically connected with each other. Each of the capacitor modules comprises a number of base capacitors arranged on a module-specific Printed Circuit Board (PCB), wherein all the base capacitors from the plurality of modules are of a single type.

Composing a composite capacitance out of a single type of base capacitors considerably simplifies both its production and maintenance. The spatial flexibility gained by the use of a plurality of electrically interconnected capacitor modules is advantageous in those electrical power devices where the volume available for the capacitive component inside the device might be limited or otherwise constrained in at least one direction. A geometrically flexible arrangement enabled by distinct capacitor modules, including the possibility of arranging them at an arbitrary angle to each other and to occupy peripheral areas in the power device which conventional capacitive components are unable to fill, ultimately consumes less space within the power device.

According to a preferred embodiment of the present invention, at least one of the capacitor modules is mounted on and electrically connected to a support board with a central axis of all its base capacitors arranged substantially parallel to the surface of the support board.

According to another preferred embodiment of the present invention, the base capacitors of one module are arranged on one side or on both sides of the module-specific PCB. The base capacitors are electrically connected through printed circuits on or within the module-specific PCB in order to constitute the total capacitance of the capacitor module.

According to another preferred embodiment of the present invention, the modules comprise additional components such as voltage dividing circuits, high frequency capacitors, charging and discharging circuits or capacitor diagnostics circuits arranged on the module-specific PCB. The additional components contribute to a more complete functionality of the composite capacitance, by simplifying a connection with other modules, extending a high frequency bandwidth and detecting the performance of the module, respectively.

According to another preferred embodiment of the present invention, the module-specific PCB may comprise holes permitting cooling air to pass through and establish a flow of cooling air in a direction parallel to the central axis of the base capacitors. The holes are provided in an area overlapping with the open area between the base capacitors where the PCB is visible when viewing the module in said direction.

The present invention also relates to a use of the above mentioned composite capacitance as a DC-Link capacitance in a space-constrained low voltage or medium voltage power frequency converter.

### Brief Description of the Drawings

Fig.1 shows a composite capacitance in accordance with the present invention;
Fig.2, 3 and 4 depict three capacitor modules for a composite capacitance;
Fig.5 and 6 show two schematic cross sections of a capacitor module;
Fig.7 depicts five capacitor modules based on five different types of base capacitors;
Fig.8 shows a schematic diagram of a prior art power frequency converter.

### Preferred Embodiments of the Invention

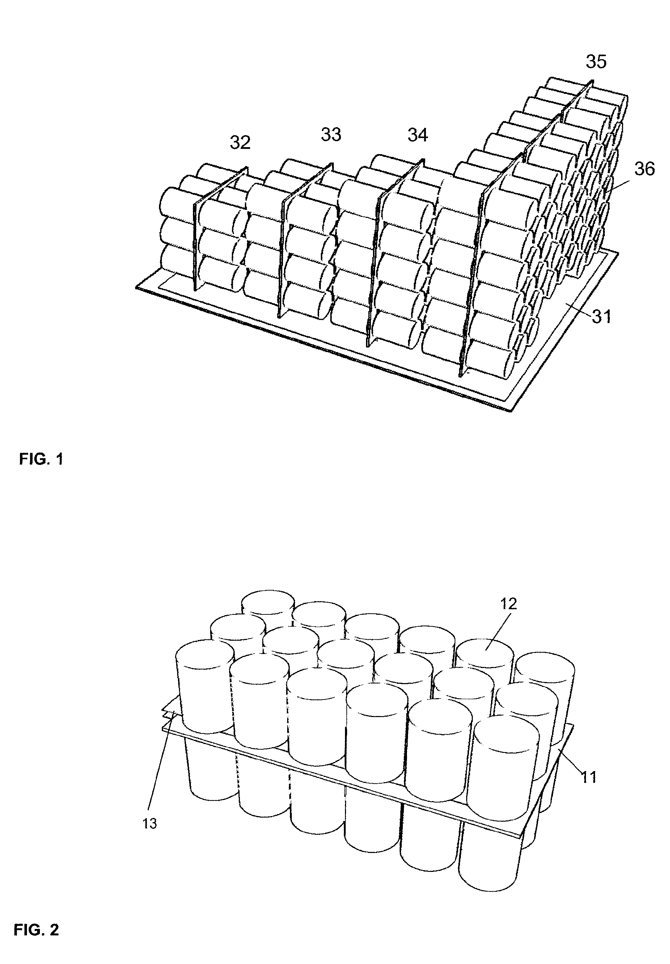

Fig.1 depicts a composite capacitance with a plurality of capacitor modules (32, 33, 34 and 35) each comprising a module-specific PCB (Printed Circuit Board) and being mounted on a support board (31). The plurality of capacitor modules are electrically connected to each other in serial and/or parallel connection by means of suitable connecting circuits on the support board. The capacitor modules and the support board together form a composite capacitance or capacitive component to be used in an electrical power device such as power frequency converter. Each capacitor module comprises one single module-specific PCB, and all the base capacitors (36) arranged on a single PCB are part of the same board-specific module. The capacitor modules are mounted on the support board in a manner such that a central axis of all the base capacitors is arranged substantially parallel to the surface of the support board.

The number of mounted modules, their mutual arrangement, and the size of each module (e.g. width, length, depth) can be selected arbitrarily, such that the resulting composite capacitance may have an overall shape that departs from a standard rectangular volume. By way of example, the arrangement of capacitor modules depicted in Fig.1 gives rise to a wedge-shaped overall volume. The total capacitance of is made up by the totality of modules mounted on the support board, the number of base capacitors on each module and the specifics of the electrical base capacitor connection.

At least two out of the plurality of capacitor modules are physically distinguishable in terms of, for example, mechanical properties or electrical properties. That is, the PCBs of these distinct modules may distinguish in shape, size, thickness, or topography. Distinct modules may also have a different number of base capacitors and/or distinguish in the internal wiring or electrical interconnection of the base capacitors. Hence the total capacitance of two distinct modules may be different or the same.

The structure and configuration of the composite capacitance is very flexible and may be optimized to adapt to or fill any available space in the electrical power device. Compared to a conventional capacitive component which uses only a single-storey volume closest to PCB surface, the proposed composite capacitance can, by stacking base capacitors, occupy additional parts of the internal space above the PCB surface. For example, the capacitor modules (32, 33, 34, 35) in Fig.1 show three to six base capacitors (36) arranged next to each other in a direction perpendicular to the support board (31). The four capacitor modules are arranged parallel to each other. However, in order to most efficiently utilize an irregular space within a particular power electrical device, two or more PCB modules may alternatively form an arbitrary angle at their intersection. Therefore, the proposed composite capacitance enables an optimized usage of the available three dimensional spaces within the electrical power device.

The modules can be mounted on the support board through various connecting means. By selecting the connecting means appropriately, the modules can be easily and repeatedly mounted and removed. That is, in case a single capacitor module does not function properly, the latter can be replaced by a spare one in a straightforward manner. Moreover, if during operation a different total capacitance should be required for the power device, modules can be added to or removed from the support board accordingly.

Under the following design aspects, it is preferable to build the capacitor module based on a large number of base capacitors with small capacitance rather than a few capacitors with large capacitance. By doing so, if only one or few base capacitors fail while the other base capacitors of the capacitor module continue to work properly the total capacitance is only slightly diminished. The reliability of the proposed module is thus improved.

Furthermore, through massive parallel connection of small capacitors on a low inductive PCB, the total equivalent stray inductance of the capacitor module becomes very low, which could result in advantageously stable switching behavior. In addition, the total heat generated by a large number of small capacitors is typically less than the heat generated by a few large capacitors of the same capacitance.

Finally, the total capacitance of the module being constituted by a great number of identical base capacitors gives rise to an appreciable economy of scale and a simplified supply chain management.

In Fig.2, a first individual capacitor module is shown. Many base capacitors (12) of a single type are mounted on a module-specific Printed Circuit Board PCB (11). The type and capacitance of the base capacitors can be arbitrarily selected according to the requirements of the intended application. In Fig.2, the base capacitors (12) are mounted on both sides of the PCB (11). Alternatively, the base capacitors (12) may be mounted on a single side of the PCB only. Considering the dimensions of the PCB and the footprint of each base capacitor, as many base capacitors as possible are mounted on the PCB. That is, by arranging base capacitors side by side in a square or even in a triangular close-packed lattice, the area of PCB surface occupied by capacitors is substantially identical with the overall surface area of the PCB.

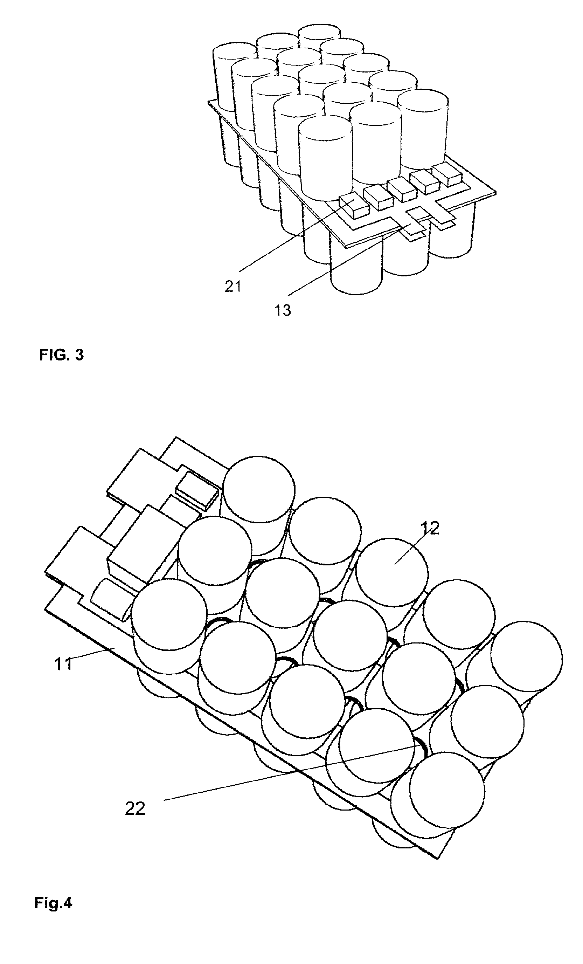

Fig.3 depicts a capacitor module with several electronic components (21) in addition to the base capacitors arranged on the PCB. Additional electronic components can be easily integrated with the capacitor module in order to improve the performance or add desired functionality. The additional components may include a voltage dividing circuit, a high frequency capacitor and a capacitor diagnostics circuit.

Specifically, dedicated high frequency capacitors connected in parallel to the main capacitors can be integrated in order to improve the frequency bandwidth of the module; and a diagnostic sensor may be integrated in order to detect and improve the signaling performance of the capacitor module. A voltage dividing circuit (e.g. parallel resistors) may be provided to allow easy series connection with other capacitor modules. Further additional functions may be added through integrating capacitor charging and discharging circuits.

As mentioned, the PCB-based capacitor modules can be equipped with various connectors for any intended purpose or application. While any commercially available type of connectors can be used as a connecting means for the capacitor module, Fig.2 and Fig.3 depict a specially designed extra-wide low impedance connector (13). The connector (13) makes it possible to easily and reversibly attach and detach the capacitor module to/from the support board.

It should be noted that although the PCBs shown in Fig.2 and 3 are of square shape, the PCBs can be designed to have any other shape as well. For example, a triangular or a circular shaped PCB is also possible and may even be preferable in view of the internal space of the electrical power device that it will be used in.

Fig.4 depicts a plurality of air convection holes (22) provided on the PCB (11) of the capacitor module. The air convection holes allow cooling air to flow in a direction parallel to the base capacitors (12) mounted on the PCB. To this end, the holes are arranged on the PCB in such a manner that the holes are at least partially visible when viewing the PCB in a direction of the base capacitors (12), i.e. the holes basically coincide with the interstices between the base capacitors.

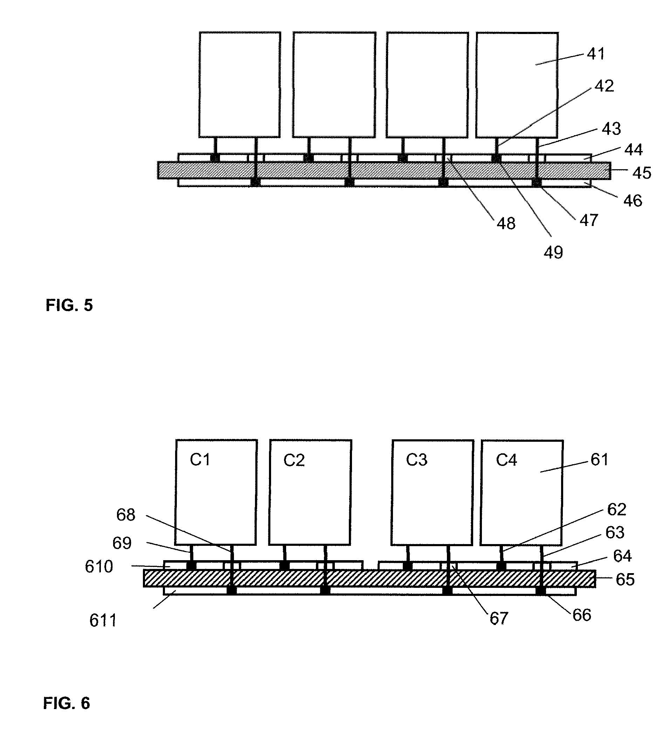

Fig.5 and Fig.6 show two out of countless possible ways of interconnecting the base capacitors on the PCB.

Fig.5 depicts a cross section of a module with all the base capacitors (41) being parallel connected and mounted on one side of the PCB. The PCB comprises three layers, a plus conducting layer (44), a minus conducting layer (46) and an insulation layer (45) sandwiched between above two conducting layers. Plus and minus pins (42, 43) of the base capacitors are connected with plus and minus conducting layers (44, 46) at pin-to-PCB connecting contacts (47, 49). In particular, the plus pin 42 connects with plus conducting layer (44) on contact (49), and the minus pin traverses the plus conducting layer (44) via an opening or recess (48) provided in the plus conducting layer, and is connected with minus conducting layer (46) at the contact point (47) at the opposite side of the PCB. In a similar way the base capacitors can be mounted on both sides of the PCB and electrically connected in parallel by means of the two conducting layers.

In Fig.6, a cross section of a module is shown, wherein, the capacitors are two-by-two series connected and mounted on one side of the PCB. Contrary to Fig.5, the upper conducting layer is divided into a first upper conducting layer (610) and a second upper conducting layer (64), which both serve as serial contacts to the abovementioned connectors or to further neighboring pairs of base capacitors.

In Fig.6, all capacitors (61) (C1 to C4) are connected with bottom conducting layer (611). However, both of the capacitors C1 and C2 are connected with the first upper conducting layer (610), and both of the capacitors C3 and C4 are connected with the second upper conducting layer (64). Therefore, the base capacitors C1 and C2 are connected in parallel as a first group; and the base capacitors C3 and C4 are connected in parallel as a second group. The first capacitor group (C1, C2) is connected with the second capacitor group (C3, C4) in series.

Fig.7 depicts five capacitor modules (71, 72, 73, 74 and 75) of substantially identical total capacitance and based on five different types of base capacitors. The geometrical and electrical arrangement of the base capacitors gives rise to the physical properties as follows.
- the first module A (71) comprises 4 base capacitors, and its total surface area is 252,675 mm²; its total volume is 7,320,404 mm³; its total impedance Zmax (10kHz, 20°C) is 5 mOhm; and its total ripple current capability I_AC max (100Hz, 85°C) is 90.2A.
- the second module B (72) comprises 6 base capacitors, and its total surface area is 247,815 mm²; its total volume is 7,179,627 mm³; its total Zmax (10kHz, 20°C) is 4.67 mOhm; its total I_AC max (100Hz, 85°C) is 97.8A.
- the third module C (73) comprises 33 base capacitors, and its total surface area is 431,624 mm²; its total volume is 7,090,664 mm³; its total Zmax (10kHz, 20°C) is 4.36 mOhm; its total I_AC max (100Hz, 85°C) is 151.8 A.
- the fourth module D (74) comprises 50 base capacitors, and its total surface area is 653,975 mm²; its total volume is 10,743,430 mm³; its total Zmax (10kHz, 20°C) is 4.88 mOhm; and its total I_AC max (100Hz, 85°C) is 170A.
- the fifth module E (75) comprises 270 base capacitors, and its total surface area is 932,877 mm²; its total volume is 6,534,000 mm³; its total Zmax (10kHz, 20°C) is 4.3 mOhm; its total I_AC max (100Hz, 85°C) is 126.9 A.

The above listed simulation results indicate that the total volume of the different modules is of little difference. However, the total surface of module 75 is about four times the one of modules 71 or 72. Accordingly, heat dissipation is expected to be of a lesser concern for module 75 than for modules 71 and 72. Furthermore, the ripple current capabilities (I_AC) of the modules 73, 74 and 75 are significantly higher than for the modules 71 and 72.

## Claims

1. A composite capacitance comprising a plurality of physically distinguishable capacitor modules which are electrically connected to each other, wherein each of the plurality of capacitor modules comprises a number of base capacitors arranged on a module-specific Printed Circuit Board PCB; and wherein all the base capacitors of the plurality of capacitor modules are of a single type.

2. The composite capacitance according to claim 1, **characterized in that** at least one of the capacitor modules is mounted on a support board with a central axis of all the base capacitors arranged substantially parallel to the surface of the support board.

3. The composite capacitance according to claim 1, **characterized in that** the base capacitors are arranged on one side or on both sides of the module-specific PCB; and **in that** the base capacitors are connected through printed circuits of the module-specific PCB.

4. The composite capacitance according to claim 1, **characterized in that** at least one of the modules comprises at least one of a voltage dividing circuit, a high frequency capacitor circuit, a charging and discharging circuit, and a capacitor diagnostics circuit arranged on the module-specific PCB.

5. The composite capacitance according to claim 1, **characterized in that** the module-specific PCB comprises holes which permit cooling air to pass through and to circulate in-between neighboring capacitors.

6. A use of a composite capacitance according to one of the preceding claims in a DC-Link of a power frequency converter.
